(19) Europäisches Patentamt
European Patent Office
Office européen des brevets

(11) Veröffentlichungsnummer : **0 354 475 B1**

# (12) EUROPÄISCHE PATENTSCHRIFT

(45) Veröffentlichungstag der Patentschrift :
**15.11.95 Patentblatt 95/46**

(51) Int. Cl.$^{6}$ : **G03F 7/11**

(21) Anmeldenummer : **89114344.8**

(22) Anmeldetag : **02.08.89**

## (54) Photopolymerisierbares Aufzeichnungsmaterial.

(30) Priorität : **11.08.88 DE 3827245**

(43) Veröffentlichungstag der Anmeldung :
**14.02.90 Patentblatt 90/07**

(45) Bekanntmachung des Hinweises auf die Patenterteilung :
**15.11.95 Patentblatt 95/46**

(84) Benannte Vertragsstaaten :
**DE FR GB NL**

(56) Entgegenhaltungen :
**FR-A- 2 122 578**
**US-A- 4 557 996**
**PATENT ABSTRACTS OF JAPAN, vol. 10, no. 300 (P-506)(2356), 14 Oktober 1986 & JP-A-61 117 549**

(73) Patentinhaber : **HOECHST AKTIENGESELLSCHAFT**
**D-65926 Frankfurt am Main (DE)**

(72) Erfinder : **Zertani, Rudolf, Dr.**
**Hans-Zöller-Strasse 111**
**D-6500 Mainz-Laubenheim (DE)**
Erfinder : **Mohr, Dieter, Dr.**
**Eaubonner Strasse 8**
**D-65001 Budenheim (DE)**
Erfinder : **Frass, Werner, Dr.**
**Erbsenacker 37**
**D-6200 Wiesbaden-Naurod (DE)**

**EP 0 354 475 B1**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein photopolymerisierbares Aufzeichnungsmaterial mit einem Schichtträger, einer photopolymerisierbaren Schicht und einer Deckschicht, die für Luftsauerstoff wenig durchlässig ist. Das Material ist besonders für die Herstellung von Druckplatten, insbesondere Flachdruckplatten, geeignet.

Druckplatten der genannten Gattung sind z. B. aus der US-A 3 458 311 bekannt. Dort werden Deckschichten beschrieben, die aus wasserlöslichen Polymeren, z. B. Polyvinylalkohol, Polyvinylpyrrolidon, Gelatine oder Gummi arabicum, bestehen. Von diesen Substanzen wird Polyvinylalkohol bevorzugt, da seine Dämmwirkung gegenüber Sauerstoff sehr hoch ist.

Die überwiegende Mehrzahl der gegenwärtig hergestellten Flachdruckplatten auf Basis von photopolymerisierbaren Materialien weist gegenüber negativ arbeitenden Druckplatten auf Basis von Diazoniumverbindungen eine deutlich schlechtere Auflösung auf. Es wird angenommen, daß dieser Auflösungsverlust teilweise durch eine sich in der Schicht fortpflanzende Dunkelreaktion nach der durch Licht initiierten Polymerisation der Bildstellen verursacht wird. Auch wird als Ursache am Schichtträger reflektiertes Streulicht vermutet. Eine Verbesserung der Auflösung kann deshalb durch Einsatz von Lichthofschutzschichten zwischen Trägeroberfläche und photopolymerisierbarer Schicht oder durch Zusatz von Farbstoffen oder UV-Absorbern zur photopolymerisierbaren Schicht selbst erreicht werden. Dabei werden grundsätzlich Farbstoffe bzw. Pigmente eingesetzt, die im Wellenlängenbereich der Schichtempfindlichkeit absorbieren. Derartige Materialien sind in den US-A 2 791 504, 4 173 673 und DE-A 22 02 360 und 26 58 422 beschrieben. Die hier beschriebenen Farbstoffe reduzieren insbesondere den Streulichtanteil, der durch Reflexion an der Trägeroberfläche entsteht. Eine Verbesserung der Auflösung durch Zusatz von Farbstoffen zur lichtempfindlichen Schicht selbst läßt sich insbesondere mit solchen Farbstoffen erzielen, die im Bereich von 350 bis 450 nm absorbieren. Die Verbesserung wird dabei stets durch eine erhebliche Abnahme der Lichtempfindlichkeit erkauft.

In der US-A 3 218 167 wird ein photopolymerisierbares Material für die Herstellung von Übertragungsbildern nach dem peel-apart-Verfahren beschrieben. Da dieses Verfahren einen deutlichen Bildkontrast erfordert, muß die photopolymerisierbare Schicht durch Farbstoffzusatz stark gefärbt sein. Um dadurch die Lichtempfindlichkeit nicht zu stark herabzusetzen, soll der Farbstoff im aktinischen Bereich der Photopolymerschicht möglichst wenig absorbieren. Da die meisten verwendeten Farbstoffe auch im Anregungsbereich des Photoinitiators noch relativ viel Licht absorbieren, wird die Lichtempfindlichkeit in der Regel stark vermindert. Eine andere Wirkung des Farbstoffzusatzes wird nicht erwähnt.

Es ist auch bekannt, durch Zusatz von Polymerisationsinhibitoren die Dunkelreaktion zu hemmen und auch auf diese Weise die Auflösung zu verbessern. Wenn diese Initiatoren voll wirksam sind, haben sie zumeist den Nachteil, die Lichtempfindlichkeit herabzusetzen. Auch ergeben viele dieser Inhibitoren bei längerer Lagerung eine unerwünschte Verfärbung der Schicht. Viele der bekannten Inhibitoren oder ihre Folgeprodukte absorbieren in dem für die Anregung der Photopolymerisation wichtigen Wellenlängenbereich von 300 bis 700 nm und stören oder hemmen dadurch die bildmäßige Polymerisation.

Aus der internationalen Patentanmeldung WO 86/7473 ist es bekannt, bei positiv arbeitenden Photoresistmaterialien auf Basis von Naphthochinondiaziden eine kontrastverstärkende Deckschicht aufzubringen, die bei Belichtung im aktinischen Bereich ausbleicht. Durch die erhöhte Bildschärfe wird auch die Auflösung dieser an sich schon hochauflösenden Materialien verbessert.

In der WO 86/6182 wird ein Farbprüfverfahren beschrieben, bei dem zur Verhinderung der Rasterpunktvergrößerung (dot gain) und zur Erweiterung des Belichtungsspielraums eine optische Filterschicht zwischen der positiv arbeitenden lichtempfindlichen Schicht der Farbprüffolie und dem Farbauszug angebracht wird. Die Filterschicht muß Licht im Bereich der größten Lichtabsorption der lichtempfindlichen Schicht absorbieren.

In der DE-C 21 23 702 wird ein photopolymerisierbares Trockenresistmaterial beschrieben, das zwischen der abtrennbaren temporären Trägerfolie und der photopolymerisierbaren Schicht eine Trennschicht aufweist, die eine sauerstoffhemmende Verbindung enthält. Diese Trennschicht kann auch mit einer kleinen Menge eines Farbstoffs angefärbt sein, ohne daß hierfür eine besondere Wirkung angegeben ist.

In der JP-A 117.549/86 wird ein photopolymerisierbares Material beschrieben, dessen photopolymerisierbare Schicht ein Bindemittel, einen Photoinitiator und einen Ester oder ein Amid der (Meth)acrylsäure enthält. Diese Ester oder Amide enthalten keine photooxydierbaren Gruppen; der Photoinitiator ist kein photoreduzierbarer Farbstoff. Auf der photopolymerisierbaren Schicht befindet sich eine für Sauerstoff undurchlässige Deckschicht, die ein wasserlösliches Polymeres und einen wasserlöslichen Farbstoff enthält, der Licht im Bereich von 300 bis 700 nm absorbiert und innerhalb dieses Bereichs eine Absorptionslücke hat und der dazu dient, Beschichtungsfehler in der Deckschicht auch unter Sicherheitslicht besser zu erkennen.

Aufgabe der Erfindung war es, das Auflösungsvermögen hochlichtempfindlicher photopolymerisierbarer Schichten auf Basis von polymerisierbaren Verbindungen mit photooxydierbaren Gruppen in Verbindung mit photoreduzierbaren Farbstoffen und ggf. weiteren synergistisch wirkenden Verbindungen als Photoinitiatoren,

insbesondere in Materialien für die Herstellung von Flachdruckplatten, zu verbessern, ohne daß zugleich die Lichtempfindlichkeit wesentlich vermindert wird.

Die Aufgabe wird gelöst durch ein Aufzeichnungsmaterial der im Anspruch 1 angegebenen Zusammensetzung.

Als Farbstoff soll im Sinne dieser Erfindung jede Verbindung mit einer intensiven Lichtabsorption in dem genannten Spektralbereich verstanden werden, also auch Verbindungen, die im UV-Bereich absorbieren und im sichtbaren Spektralbereich wenig oder gar nicht gefärbt sind.

Geeignete Farbstoffe sind demnach u. a. UV-Absorber, lichtempfindliche Verbindungen, wie Diazoniumsalze und 1,2-Chinondiazide, Di- oder Triarylcarbenium-, Azo-, Aza(18)annulen-, Nitro-, Nitroso-, Polymethin-, Carbonyl- oder Schwefelfarbstoffe.

Von diesen Farbstoffen werden Carbonyl-, insbesondere Anthrachinonfarbstoffe, Azo-, Triarylcarbenium-, insbesondere Triphenylmethan-, Aza(18)annulen-, z. B. Porphyrin- oder Phthalocyaninfarbstoffe, soweit sie wasserlöslich sind, und Polymethinfarbstoffe bevorzugt.

Beispiele für geeignete Farbstoffe sind:
2,2′-Dihydroxy-4-methoxybenzophenon 4-Dodecyloxy-2-hydroxy-benzophenon, 2,4-Dihydroxybenzophenon, Hydroxyphenylbenzotriazol, Resorcinmonobenzoat, Oil-Orange (C.I. 12055), Sudan-Orange RA (C.I. 12055), Capracyl-Orange (C.I. 60), Sudangelb (C.I. 30), Siriuslichtgelb R extra (C.I. 29025), Remazolbrillantorange RR (C.I. 17756), Remazolbrillantorange 3R (C.I. 17757) Remazolgoldgelb G (C.I. 18852), Remazolgelb RTL (Reactive Yellow 24), Echtlichtgelb 3G (C.I. 19120), Astrazongelb 3G (C.I. 48055), Astrazongelb 5G (C.I. 48065) oder Basic Yellow 52115 (C.I. 48060), Astrazonorange 3R (Basic Orange 22), Astrazongelb 7 GLL, Astrazongelb GRL, Astrazongelbbraun 3 GL (Basic Orange 3012), Astrazonblau 3 RL (Basic Blue 47), Basic Blue 3 RL, Methylenblau, Irgacetblau 2 GLN, Bromphenolblau (CAS-62625-28-9), Servablau G, Corvolingelb HG, Novofil-Gelb GR (Pigment Yellow 13), Orasolgelb, Remazolgelb, Tartrazin, Zaponechtgelb CGG, Fettgelb, Maxilonbrillantgelb, Remacrylgelb, Astrazonrotviolett 3 RN, Astrazonviolett F3 RL, Astrazongrün M, Brillantgrün (42040), Methylorange, Methylrot, Duasynsäureblau R, Viktoriablau FB (44045), Orasolrot B, Remazolgoldorange, Orasolorange RW-A, Säuregrün, Maxilonrot GRL, Maxilonrot BL-N, Nubilonorange R (Acid Orange 7) und Astragelb R. Als besonders geeignet haben sich erwiesen Astrazonorange R (C.I. 48040), Astrazongelbbraun 3 GL, Bromphenolblau, Methylenblau, Maxilonblau GRL und Astrazonblau 3 RL. Außerdem sind noch Oxdiazolderivate gemäß DE-A 1 058 836, 6-Phenyl-2-pyrone (DE-A 16 68 358), 4,4′-Dibenzalacetone, z. B. 4-Diethylamino-4′-methoxy-dibenzalaceton, und Cumarinderivate wie 3-Acetyl-7-diethylamino-cumarin sehr gut geeignet.

Weiterhin sind als lichtempfindliche Verbindungen auch Diazoniumsalze bzw. Chinondiazide, welche in einem Spektralbereich von 280 bis 450 nm empfindlich sind, geeignet. Durch Einarbeitung dieser gelb gefärbten Komponenten in die Deckschicht läßt sich ebenfalls das Auflösevermögen einer negativ arbeitenden Schicht deutlich verbessern.

Aus einer panchromatisch sensibilisierten Photopolymerschicht, die in einem Spektralbereich von 300 bis 700 nm empfindlich ist, lassen sich durch Aufbringen von optischen Filterschichten "optische Fenster", abhängig vom gewählten Farbstoff und seinem Absorptionsverhalten, erzeugen. Hierdurch lassen sich basierend auf einer einzigen hochlichtempfindlichen Photopolymerschicht z. B. Druckplatten für folgende verschiedene Anwendungsbereiche herstellen:

a) Projektionsbelichtung (400 - 450 nm)
b) Laserbelichtung (488 und 514 nm / Ar-Ionen-Laser)
c) UV-Belichtung (≤ 400 nm)

Die in dem erfindungsgemäßen Material einzusetzenden Farbstoffe sind in der Deckschicht, welche gleichzeitig als Filterschicht und Sauerstoffbarriere wirkt, in zur Einstellung der gewünschten Eigenschaften wirksamen Menge enthalten. Die Konzentration der Farbstoffe in der Deckschicht ist dabei unter anderem dem Verwendungszweck des lichtempfindlichen Aufzeichnungsmaterials (z. B. Einsatz im Offsetdruck als Projektionsplatte, laserbebilderbare Druckplatte, UV-empfindliche Druckplatte oder als Photoresist), der Stärke der Deckschicht, dem Aufbau der photopolymerisierbaren Schicht, der Art der Sensibilisierung und auch der Art und Intensität der Lichtquellen anzupassen, und kann demzufolge in weiten Grenzen variieren.

Die Menge an Farbstoffen in der Deckschicht beträgt im allgemeinen 0,01 bis 70, vorzugsweise 0,05 bis 50 und insbesondere 0,5 bis 25 Gew.-%. Sie sollte so bemessen werden, daß die Deckschicht im Absorptionsbereich des Farbstoffs eine optische Dichte von 0,5 bis 2,5 hat.

Das für Luftsauerstoff wenig durchlässige Polymere kann eines der in der US-A 3 458 311 angegebenen Polymeren sein. Beispiele sind insbesondere Polyvinylalkohol und teilverseifte Polyvinylacetate, die auch Vinylether- und Vinylacetaleinheiten enthalten können, solange das Polymere bei 20 °C in Wasser oder einem Gemisch aus Wasser und einem niederen Alkohol, z. B. Ethanol, das bis zu 50 %,vorzugsweise bis zu 30 % Alkohol enthält, löslich bleibt. Ferner können Gelatine, Gummi arabicum, Mischpolymerisate von

Alkylvinylethern und Maleinsäureanhydrid, Polyvinylpyrrolidone, Polycarbonsäuren, wasserlösliche hochmolekulare Polymerisate von Ethylenoxid (M = 100 000 bis 3 000 000), wasserlösliche Pfropfmischpolymerisate von Ethylenoxid auf Polyvinylalkohol, Kohlenhydrate und Hydroxyethylcellulose eingesetzt werden. Bevorzugt werden solche Polymere, deren Sauerstoffdurchlässigkeit in einer Schicht bei 20 °C kleiner als 30, insbesondere kleiner als 25 $cm^3/m^2/d/bar$ ist.

Die Deckschicht soll für aktinisches Licht durchlässig sein und hat im allgemeinen eine Dicke von 0,5 bis 10, vorzugsweise 1 bis 4 µm. Die Deckschicht wird in bekannter Weise aus wäßriger Lösung oder aus einem Gemisch von Wasser und organischem Lösemittel auf die photopolymerisierbare Schicht aufgebracht. Der Beschichtungslösung können zur besseren Benetzung bis zu 10 Gew.-%, vorzugsweise bis zu 5 Gew.-% eines oberflächenaktiven Mittels, bezogen auf ihren Feststoffgehalt, zugesetzt werden. Zu den brauchbaren oberflächenaktiven Substanzen gehören die anionischen, kationischen und nichtionischen oberflächenaktiven Mittel, z. B. Natriumalkylsulfate und -sulfonate mit 12 bis 18 Kohlenstoffatomen wie Natriumdodecylsulfat, N-Cetyl- und C-Cetylbetaine, Alkylaminocarboxylate und -dicarboxylate sowie Polyethylenglykole mit einem durchschnittlichen Molekulargewicht bis 400.

Die photopolymerisierbaren Schichten der erfindungsgemäßen Aufzeichnungsmaterialien enthalten als wesentliche Bestandteile ein polymeres Bindemittel, eine radikalisch polymerisierbare Verbindung mit mindestens einer, bevorzugt mindestens zwei endständigen ethylenisch ungesättigten Gruppen und mindestens einer bei Belichtung in Gegenwart eines photoreduzierbaren Farbstoffs photooxydierbaren Gruppe sowie einen durch aktinisches Licht aktivierbaren photoreduzierbaren Farbstoff als Polymerisationsinitiator bzw. als Initiatorbestandteil.

Für die Zwecke der Erfindung geeignete polymerisierbare Verbindungen sind bekannt.

Beispiele sind Acryl- und Methacrylsäureester von zwei- oder mehrwertigen Alkoholen und von mehrwertigen alicyclischen Alkoholen oder N-substituierte Acryl- und Methacrylsäureamide, die mindestens eine photooxydierbare und gegebenenfalls mindestens eine Urethangruppe im Molekül enthalten. Als photooxydierbare Gruppen kommen insbesondere Aminogruppen, Harnstoffgruppen, Thiogruppen, die auch Bestandteile hererocyclischer Ringe sein können, und Enolgruppen in Betracht. Beispiele für derartige Gruppen sind Triethanolamino-, Triphenylamino-, Thioharnstoff-, Imidazol-, Oxazol-, Thiazol-, Acetylacetonyl-, N-Phenylglycin- und Ascorbinsäuregruppen. Polymerisierbare Verbindungen mit primären, sekundären und insbesondere tertiären Aminogruppen werden bevorzugt.

Beispiele für Verbindungen mit photooxydierbaren Gruppen sind Acryl- und Alkacrylsäureester der Formel I

$$R_{(m-n)}Q\left[(-CH_2-\underset{R^2}{\overset{R^1}{C}}O)_a-CONH(X^1-NHCOO)_b-X^2(-OOC-\overset{R^3}{C}=CH_2)_c\right]_n \quad (I)$$

worin

Q

-N-, -N-E-N-, 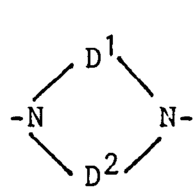

oder -S-

| | |
|---|---|
| R | eine Alkyl-, Hydroxyalkyl- oder Arylgruppe, |
| $R^1$ und $R^2$ | jeweils ein Wasserstoffatom, eine Alkylgruppe oder Alkoxyalkylgruppe, |
| $R^3$ | ein Wasserstoffatom, eine Methyl- oder Ethylgruppe, |
| $X^1$ | eine gesättigte Kohlenwasserstoffgruppe mit 2 bis 12 Kohlenstoffatomen, |
| $X^2$ | eine (c+1)-wertige gesättigte Kohlenwasserstoffgruppe, in der bis zu 5 Methylengruppen durch Sauerstoffatome ersetzt sein können, |
| $D^1$ und $D^2$ | jeweils eine gesättigte Kohlenwasserstoffgruppe mit 1 bis 5 Kohlenstoffatomen, E eine gesättigte Kohlenwasserstoffgruppe mit 2 bis 12 Kohlenstoffatomen, eine cycloaliphatische Gruppe mit 5 bis 7 Ringgliedern, die ggf. bis zu zwei N-, O- oder S-Atome als Ringglieder enthält, eine |

Arylengruppe mit 6 bis 12 Kohlenstoffatomen oder eine heterocyclische aromatische Gruppe mit 5 oder 6 Ringgliedern,

a 0 oder eine ganze Zahl von 1 bis 4,
b 0 oder 1,
c eine ganze Zahl von 1 bis 3,
m je nach Wertigkeit von Q 2, 3 oder 4 und
n eine ganze Zahl von 1 bis m

bedeutet, wobei alle Symbole gleicher Definition untereinander gleich oder verschieden sein können.

Die Verbindungen dieser Formel, ihre Herstellung und Verwendung sind ausführlich in der älteren EP-A 287818 beschrieben.

Wenn in der Verbindung der allgemeinen Formel I mehr als ein Rest R oder mehr als ein Rest des in eckigen Klammern angegebenen Typs an die zentrale Gruppe Q gebunden ist, so können diese Reste untereinander verschieden sein.

Verbindungen, in denen alle Substituenten von Q polymerisierbare Reste sind, d. h. in denen m = n ist, werden im allgemeinen bevorzugt.

Im allgemeinen ist in nicht mehr als einem Rest a = 0, vorzugsweise ist a = 1.

Wenn R eine Alkyl- oder Hydroxyalkylgruppe ist, hat diese im allgemeinen 2 bis 8, vorzugsweise 2 bis 4 Kohlenstoffatome. Der Arylrest R kann im allgemeinen ein- oder zweikernig, bevorzugt einkernig und gegebenenfalls durch Alkyl- oder Alkoxygruppen mit bis zu 5 Kohlenstoffatomen oder Halogenatomen substituiert sein.

Wenn $R^1$ und $R^2$ Alkyl- oder Alkoxyalkylgruppen sind, können diese 1 bis 5 Kohlenstoffatome enthalten.

$R^3$ ist bevorzugt ein Wasserstoffatom oder eine Methylgruppe, insbesondere eine Methylgruppe.

$X^1$ ist bevorzugt ein geradkettiger oder verzweigter aliphatischer oder cycloaliphatischer Rest mit vorzugsweise 4 bis 10 Kohlenstoffatomen.

$X^2$ hat vorzugsweise 2 bis 15 Kohlenstoffatome, von denen bis zu 5 durch Sauerstoffatome ersetzt sein können. Wenn es sich um reine Kohlenstoffketten handelt, werden im allgemeinen solche mit 2 bis 12, vorzugsweise 2 bis 6 Kohlenstoffatomen eingesetzt. $X^2$ kann auch eine cycloaliphatische Gruppe mit 5 bis 10 Kohlenstoffatomen, insbesondere eine Cyclohexylengruppe sein.

$D^1$ und $D^2$ können gleich oder verschieden sein und bilden zusammen mit den beiden Stickstoffatomen einen gesättigten heterocyclischen Ring mit 5 bis 10, vorzugsweise 6 Ringgliedern.

Wenn E eine Alkylengruppe ist, hat diese vorzugsweise 2 bis 6 Kohlenstoffatome, als Arylengruppe ist es bevorzugt eine Phenylengruppe. Als cycloaliphatische Gruppen werden Cyclohexylengruppen, als aromatische Heterocyclen solche mit N oder S als Heteroatomen und mit 5 oder 6 Ringgliedern bevorzugt.

Der Wert von c ist vorzugsweise 1.

Die polymerisierbaren Verbindungen der Formel I, die zwei Urethangruppen in jedem Rest (b = 1) enthalten, werden dargestellt, indem Acryl- oder Alkylacrylsäureester, die freie Hydroxygruppen enthalten, in bekannter Weise mit der gleichen Molmenge an Diisocyanaten umgesetzt werden und die überschüssige Isocyanatgruppe mit Hydroxyalkylaminen, N,N-Bis-hydroxyalkyl-piperazinen oder N,N,N′,N′-Tetra-hydroxyalkyl-alkylendiaminen, umgesetzt wird, wobei einzelne Hydroxyalkylgruppen durch Alkyl- oder Arylgruppen R ersetzt sein können. Wenn a = 0 ist, entsteht eine Harnstoffgruppierung.

Beispiele für die als Ausgangsstoffe verwendeten Hydroxyalkylamine sind Triethanolamin, N-Alkyl-N,N-di(hydroxyalkyl)amine, Diethanolamin, Tris-(2-hydroxypropyl)amin oder Tris-(2-hydroxybutyl)amin.

Beispiele für die als Ausgangsstoffe verwendeten Diisocyanate sind Hexamethylendiisocyanat, 2,2,4-Trimethylhexamethylendiisocyanat, 1,4-Cyclohexylendiisocyanat und 1,1,3-Trimethyl-3-isocyanatomethyl-5-isocyanatocyclohexan.

Als Hydroxygruppen enthaltende Ester werden insbesondere Hydroxyethylmethacrylat und Hydroxypropylmethacrylat (n oder iso) sowie die entsprechenden Acrylate verwendet.

Die polymerisierbaren Verbindungen der Formel I mit b = 0 werden dargestellt, indem die oben beschriebenen Hydroxyalkylaminoverbindungen mit Isocyanatgruppen enthaltenden Acryl- oder Alkylacrylsäureestern umgesetzt werden. Als Isocyanatgruppen enthaltender Ester wird insbesondere Isocyanatoethyl(meth)acrylat eingesetzt.

Weitere geeignete Verbindungen mit photooxydierbaren Gruppen sind Verbindungen der Formel II

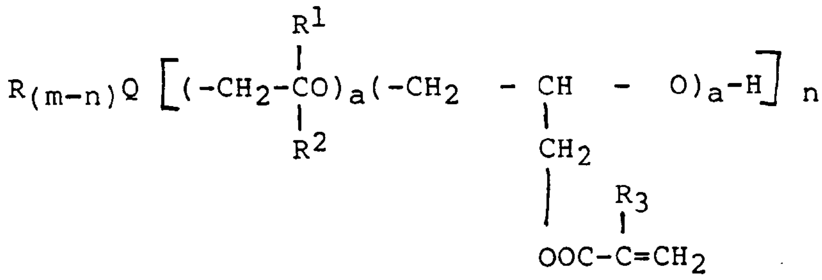 (II)

worin Q, R, $R^1$, $R^2$, $R^3$, a, m und n die oben angegebene Bedeutung haben und Q zusätzlich eine Gruppe

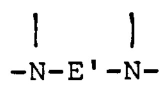

sein kann, worin E′ eine Gruppe der Formel III

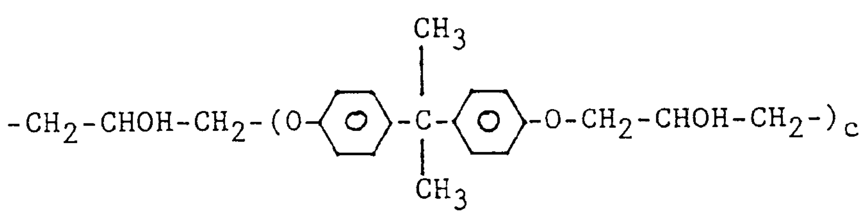 (III),

ist, in der c die Bedeutung wie in Formel I hat.

Die Herstellung der Verbindungen der Formel II erfolgt analog derjenigen der Formel I, wobei anstelle von Hydroxyalkyl(alk)acrylaten die entsprechenden (Alk)acrylsäureglycidylester eingesetzt werden.

Die Verbindungen dieser Formel, ihre Herstellung und Verwendung sind ausführlich in der älteren EP-A 316 706 beschrieben.

Weitere geeignete Verbindungen mit photooxydierbaren Gruppen sind Acryl- und Alkacrylsäureester der Formel IV

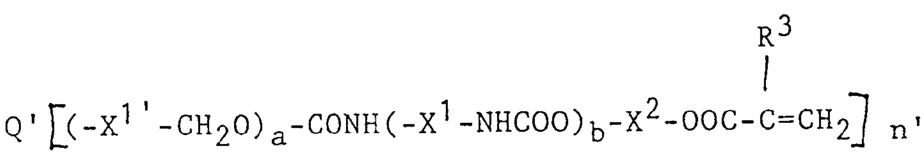 (IV)

worin

Q′

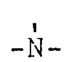,

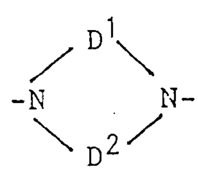 oder

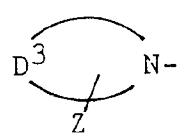,

X1′ $C_iH_{2i}$ oder

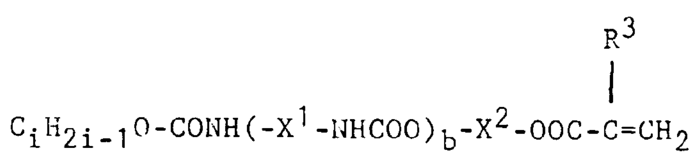,

$D^3$ eine gesättigte Kohlenwasserstoffgruppe mit 4 bis 8 Kohlenstoffatomen, die mit dem Stickstoffatom einen 5- oder 6-gliedrigen Ring bildet,

Z ein Wasserstoffatom oder einen Rest der Formel

$$C_kH_{2k}\text{-O-CONH}(\text{-}X^1\text{-NHCOO})_b\text{-}X^2\text{-OOC}(R^3)\text{=}CH_2,$$

i und k ganze Zahlen von 1 bis 12,

n′ je nach Wertigkeit von Q′ 1, 2 oder 3

bedeutet, und $R^3$, $X^1$, $X^2$, $D^1$, $D^2$, a und b die bei Formel I angegebene Bedeutung haben, wobei alle Symbole gleicher Definition untereinander gleich oder verschieden sein können und wobei in mindestens einem Substituenten an der Gruppe Q a = 0 ist.

Von den Verbindungen der Formel IV werden solche bevorzugt, die außer einer Harnstoffgruppe mindestens eine Urethangruppe enthalten. Als Harnstoffgruppen sollen Gruppen der Formel

$$>N - CO - N<$$

angesehen werden, bei denen die Valenzen am Stickstoff mit ggf. substituierten Kohlenwasserstoffresten abgesättigt sind. Es kann aber auch eine Valenz an einem Stickstoffatom an eine weitere Carbonylamidgruppe (CONH) gebunden sein, so daß eine Biuretstruktur entsteht.

Das Symbol a ist in Formel IV vorzugsweise 0 oder 1; i ist vorzugsweise eine Zahl von 2 bis 10.

Die polymerisierbaren Verbindungen der Formel IV werden analog zu den Verbindungen der Formel I hergestellt.

Die Verbindungen der Formel IV und ihre Herstellung sind ausführlich in der älteren EP-A 355 387 beschrieben.

Der Mengenanteil der photopolymerisierbaren Schicht an polymerisierbaren Verbindungen beträgt im allgemeinen etwa 10 bis 80, bevorzugt 20 bis 60 Gew.-%, bezogen auf die nichtflüchtigen Bestandteile.

Beispiele für verwendbare Bindemittel sind chloriertes Polyethylen, chloriertes Polypropylen, Poly(meth)acrylsäurealkylester, bei denen die Alkylgruppe z. B. Methyl, Ethyl, n-Butyl, i-Butyl, n-Hexyl oder 2-Ethylhexyl ist, Copolymere der genannten (Meth)acrylsäurealkylester mit mindestens einem Monomeren, wie Acrylnitril, Vinylchlorid, Vinylidenchlorid, Styrol oder Butadien; Polyvinylchlorid, Vinylchlorid/ Acrylnitril-Copolymere, Polyvinylidenchlorid, Vinylidenchlorid/Acrylnitril-Copolymere, Polyvinylacetat, Polyvinylalkohol, Polyacrylnitril, Acrylnitril/Styrol-Copolymere, Acrylnitril/Butadien/Styrol-Copolymere, Polystyrol, Polymethylstyrol, Polyamide (z. B. Nylon-6), Polyurethane, Methylcellulose, Ethylcellulose, Acetylcellulose, Polyvinylformal und Polyvinylbutyral.

Besonders geeignet sind Bindemittel, die in Wasser unlöslich, in organischen Lösemitteln löslich und in wäßrig-alkalischen Lösungen löslich oder zumindest quellbar sind.

Besonders erwähnt werden sollen Carboxylgruppen enthaltende Bindemittel, z. B. Copolymerisate aus (Meth)acrylsäure und/oder deren ungesättigten Homologen, wie Crotonsäure, Copolymerisate des Maleinsäureanhydrids oder seiner Halbester, Umsetzungsprodukte hydroxylgruppenhaltiger Polymerer mit Dicarbonsäureanhydriden sowie deren Mischungen.

Weiterhin sind geeignet Umsetzungsprodukte aus Polymeren, die H-acide Gruppen tragen, welche ganz oder teilweise mit aktivierten Isocyanaten umgesetzt wurden, wie beispielsweise Umsetzungsprodukte aus hydroxylgruppenhaltigen Polymeren mit aliphatischen oder aromatischen Sulfonylisocyanaten oder Phosphinsäureisocyanaten.

Darüber hinaus sind geeignet: Hydroxylgruppen enthaltende Polymere, wie beispielsweise Copolymere von Hydroxyalkyl(meth)acrylaten, Copolymere des Allylalkohols, Copolymere des Vinylalkohols, Polyurethane oder Polyester, sowie Epoxyharze, sofern sie eine ausreichende Anzahl von freien OH-Gruppen tragen, oder derart modifiziert sind, daß sie in wäßrig-alkalischen Lösungen löslich sind, oder solche Polymere, die aromatisch gebundene Hydroxylgruppen tragen, wie beispielsweise Kondensationsprodukte von kondensationsfähigen Carbonylverbindungen, insbesondere Formaldehyd, Acetaldehyd oder Aceton, mit Phenolen oder Copolymerisate der Hydroxystyrole. Schließlich lassen sich auch Copolymerisate des (Meth)acrylsäureamids mit Alkyl(meth)acrylaten verwenden.

Die vorstehend beschriebenen Polymeren sind insbesondere dann geeignet, wenn sie ein Molekulargewicht zwischen 500 und 200 000 oder darüber, bevorzugt 1 000 bis 100 000 aufweisen und entweder Säurezahlen zwischen 10 und 250, bevorzugt von 20 bis 200, oder Hydroxylzahlen zwischen 50 und 750, bevorzugt

von 100 bis 500, aufweisen.

Als bevorzugte alkalilösliche Bindemittel seien nachstehend erwähnt:

Copolymerisate der (Meth)acrylsäure mit Alkyl(meth)acrylaten, (Meth)acrylsäurenitril oder dergleichen, Copolymerisate der Crotonsäure mit Alkyl(meth)acrylaten, (Meth)acrylsäurenitril oder dergleichen, Copolymerisate der Vinylessigsäure mit Alkyl(meth)acrylaten, Copolymerisate des Maleinsäureanhydrids mit ggf. substituierten Styrolen, ungesättigten Kohlenwasserstoffen, ungesättigten Ethern oder Estern, Veresterungsprodukte der Copolymerisate des Maleinsäureanhydrids, Veresterungsprodukte von Hydroxylgruppen enthaltenden Polymeren mit Anhydriden von Di- oder Polycarbonsäuren, Copolymerisate der Hydroxyalkyl(meth)acrylate mit Alkyl(meth)acrylaten, (Meth)acrylsäurenitril oder dergleichen, Copolymerisate des Allylalkohols mit ggf. substituierten Styrolen, Copolymerisate des Vinylalkohols mit Alkyl(meth)acrylaten oder anderen polymerisationsfähigen ungesättigten Verbindungen, Polyurethane, sofern sie eine ausreichende Anzahl freier OH-Gruppen aufweisen, Epoxyharze, Polyester, teilverseifte Vinylacetat-Copolymere, Polyvinylacetale mit freien OH-Gruppen, Copolymerisate der Hydroxystyrole mit Alkyl(meth)acrylaten oder dergleichen, Phenol-Formaldehyd-Harze, z. B. Novolake.

Die Menge des Bindemittels in der lichtempfindlichen Schicht beträgt im allgemeinen 20 bis 90, vorzugsweise 40 bis 80 Gew.-%.

Als Photoinitiatoren können neben den photoreduzierbaren Farbstoffen eine Vielzahl von Substanzen Verwendung finden. Beispiele sind solche, die sich vom Grundkörper der Mehrkernchinone, Acridine und Chinazoline ableiten; ferner Trichlormethyl-s-triazine, 2-Halogenmethyl-5-vinyl-1,3,4-oxadiazolderivate, mit Trichlormethylgruppen substituierte Halogenoxazole oder Trihalogenmethylgruppen enthaltende Carbonylmethylenheterocyclen, wie sie in der DE-A 33 33 450 angegeben sind.

Bevorzugt werden als Photoinitiatoren photoreduzierbare Farbstoffe in Kombination mit durch Belichtung spaltbaren Trihalogenmethylverbindungen und gegebenenfalls mit als Photoinitiatoren wirksamen Acridin-, Phenazin- oder Chinoxalinverbindungen, wie sie in den älteren EP-A 287 817 und 284 938 beschrieben sind.

Geeignete photoreduzierbare Farbstoffe sind insbesondere Xanthen-, Benzoxanthen-, Benzothioxanthen-, Thiazin-, Pyronin, Porphyrin- oder Acridinfarbstoffe. Die Menge des Farbstoffs liegt im allgemeinen zwischen 0,01 und 10, vorzugsweise zwischen 0,05 und 4 Gew.-%, bezogen auf die nichtflüchtigen Bestandteile der Schicht.

Zur Steigerung der Lichtempfindlichkeit können den Schichten Verbindungen mit photolytisch spaltbaren Trihalogenmethylgruppen, die als radikalbildende Photoinitiatoren für photopolymerisierbare Gemische an sich bekannt sind, zugesetzt werden. Als derartige Coinitiatoren haben sich besonders Verbindungen mit Chlor und Brom, insbesondere Chlor, als Halogene bewährt. Die Trihalogenmethylgruppen können direkt oder über eine durchkonjugierte Kette an einen aromatischen carbo- oder heterocyclischen Ring gebunden sein. Bevorzugt werden Verbindungen mit einem Triazinring im Grundkörper, der bevorzugt 2 Trihalogenmethylgruppen trägt, insbesondere solche, wie sie in der EP-A 137 452, der DE-A 27 18 259 und der DE-A 22 43 621 beschrieben sind. Diese Verbindungen haben starke Lichtabsorptionen im nahen UV-Bereich, etwa um 350-400 nm. Es sind auch Coinitiatoren geeignet, die selbst im Spektralbereich des Kopierlichts nicht oder nur wenig absorbieren, wie Trihalogenmethyltriazine, die Substituenten mit kürzeren mesomeriefähigen Elektronensystemen oder aliphatische Substituenten enthalten. Auch Verbindungen mit anderem Grundgerüst, die im kürzerwelligen UV-Bereich absorbieren, z. B. Phenyl-trihalogenmethyl-sulfone oder Phenyl-trihalogenmethyl-ketone, z. B. das Phenyl-tribrommethylsulfon, sind geeignet.

Diese Komponenten werden im allgemeinen in einer Menge von 0,01 bis 10, vorzugsweise von 0,05 bis 6 Gew.-%, bezogen auf die nichtflüchtigen Bestandteile der Schicht, eingesetzt.

Die erfindungsgemäßen Materialien enthalten vorzugsweise als weiteren Initiatorbestandteil eine Acridin-, Phenazin- oder Chinoxalinverbindung. Diese Verbindungen sind als Photoinitiatoren bekannt und in den DE-C 20 27 467 und 20 39 861 beschrieben. Durch diese Verbindungen wird die Empfindlichkeit des Gemischs vor allem im nahen Ultraviolettbereich gesteigert. Die Menge dieser Komponente liegt ebenfalls im Bereich von 0,01 bis 10 Gew.-%, vorzugsweise zwischen 0,05 und 5 Gew.-%.

Wenn eine weitere Empfindlichkeitssteigerung im sichtbaren Spektralbereich erwünscht ist, kann diese durch Zusatz einer Verbindung vom Dibenzalaceton- oder Cumarintyp erreicht werden. Dieser Zusatz bewirkt eine höhere Auflösung der Kopie und eine durchgehende Sensibilisierung des Gemischs für den sichtbaren Spektralbereich bis zu Wellenlängen von etwa 600 nm. Die Menge dieser Verbindung liegt ebenfalls im Bereich von 0,01 bis 10, vorzugsweise von 0,05 bis 4 Gew.-%.

Die Gesamtmenge an Polymerisationsinitiatoren liegt im allgemeinen bei 0,05 bis 20, vorzugsweise bei 0,1 bis 10 Gew.-%.

Die photopolymerisierbaren Schichten können je nach geplanter Anwendung und je nach den gewünschten Eigenschaften verschiedenartige Stoffe als Zusätze enthalten. Beispiele sind: Inhibitoren zur Verhinderung der thermischen Polymerisation der Monomeren, Wasserstoffdonatoren, Farbstoffe, gefärbte und ungefärbte Pigmente, Farbbildner, Indikatoren, Weichmacher und Kettenüberträger. Diese Bestandteile sind zweckmäßig so auszuwählen, daß sie in dem für den Initiierungsvorgang wichtigen aktinischen Strahlungsbereich möglichst wenig absorbieren.

Als aktinische Strahlung soll im Rahmen dieser Beschreibung jede Strahlung verstanden werden, deren Energie mindestens der des sichtbaren Lichts entspricht. Geeignet ist vor allem sichtbares Licht und langwellige UV-Strahlung, aber auch kurzwellige UV-Strahlung, Laserstrahlung, Elektronen- und Röntgenstrahlung. Die Lichtempfindlichkeit reicht von etwa 300 nm bis 700 nm und umspannt damit einen sehr breiten Bereich.

Als Anwendungsmöglichkeiten für das erfindungsgemäße Material seien genannt: Aufzeichnungsschichten für die photomechanische Herstellung von Druckformen für den Hochdruck, den Flachdruck, den Tiefdruck, den Siebdruck, von Reliefkopien, z. B. Herstellung von Texten in Blindenschrift, von Einzelkopien, Gerbbildern, Pigmentbildern usw.. Weiter sind die Gemische zur photomechanischen Herstellung von Ätzreservagen, z. B. für die Fertigung von Namensschildern, von kopierten Schaltungen und für das Formteilätzen, anwendbar. Besondere Bedeutung haben die erfindungsgemäßen Gemische als Aufzeichnungsschichten für die Herstellung von Flachdruckplatten und für die Photoresisttechnik.

Als Schichtträger für das erfindungsgemäße Aufzeichnungsmaterial sind z. B. Aluminium, Stahl, Zink, Kupfer und Kunststoff-Folien, z. B. aus Polyethylenterephthalat oder Celluloseacetat, sowie Siebdruckträger, wie Perlongaze, geeignet. Es ist in vielen Fällen günstig, die Trägeroberfläche einer Vorbehandlung (chemisch oder mechanisch) zu unterwerfen, deren Ziel es ist, die Haftung der Schicht richtig einzustellen, die lithographischen Eigenschaften der Trägeroberfläche zu verbessern oder das Reflexionsvermögen des Trägers im aktinischen Bereich der Kopierschicht herabzusetzen (Lichthofschutz).

Die Herstellung der lichtempfindlichen Materialien erfolgt in bekannter Weise. So kann man die Schichtbestandteile in einem Lösemittel aufnehmen und die Lösung bzw. Dispersion durch Gießen, Sprühen, Tauchen, Antrag mit Walzen usw. auf den vorgesehenen Träger aufbringen und anschließend trocknen.

Durch die breite spektrale Empfindlichkeit des erfindungsgemäßen Aufzeichnungsmaterials können alle dem Fachmann geläufigen Lichtquellen verwendet werden, z. B. Röhrenlampen, Xenonimpulslampen, metallhalogeniddotierte Quecksilberdampf-Hochdrucklampen und Kohlenbogenlampen. Darüber hinaus ist bei den erfindungsgemäßen lichtempfindlichen Gemischen das Belichten in üblichen Projektions- und Vergrößerungsgeräten unter dem Licht der Meallfadenlampen und Kontaktbelichtung mit gewöhnlichen Glühbirnen möglich. Die Belichtung kann auch mit kohärentem Licht eines Lasers erfolgen. Geeignet für die Zwecke vorliegender Erfindung sind leistungsgerechte Laser, beispielsweise Argon-Ionen-, Krypton-Ionen-, Farbstoff-, Helium-Cadmium- und Helium-Neon-Laser, die insbesondere zwischen 250 und 650 nm emittieren. Der Laserstrahl kann mittels einer vorgegebenen programmierten Strich- und/oder Raster-Bewegung gesteuert werden.

Die weitere Verarbeitung der Materialien wird in bekannter Weise vorgenommen. Zur besseren Vernetzung der Schicht kann eine Nacherwärmung nach dem Belichten erfolgen. Zur Entwicklung werden sie mit einer geeigneten Entwicklerlösung, z. B. mit organischen Lösemitteln, aber bevorzugt mit einer schwach alkalischen wäßrigen Lösung, behandelt, wobei die unbelichteten Anteile der Schicht entfernt werden und die belichteten Bereiche der Kopierschicht auf dem Träger zurückbleiben. Die Entwicklerlösungen können einen kleinen Anteil, vorzugsweise weniger als 5 Gew.-%, an mit Wasser mischbaren organischen Lösemitteln enthalten. Sie können ferner Netzmittel, Farbstoffe, Salze und andere Zusätze enthalten. Bei der Entwicklung wird die gesamte Deckschicht zusammen mit den unbelichteten Bereichen der photopolymerisierbaren Schicht entfernt.

Im folgenden werden Ausführungsbeispiele für die Erfindung angegeben. Darin stehen Gewichtsteile (Gt) und Volumteile (Vt) im Verhältnis von g zu ccm. Prozent- und Mengenverhältnisse sind, wenn nichts anderes angegeben ist, in Gewichtseinheiten zu verstehen.

Beispiel 1 (Vergleichsbeispiel)

Als Schichtträger für Druckplatten wurde elektrochemisch aufgerauhtes und anodisiertes Aluminium mit einer Oxidschicht von 3 $g/m^2$ verwendet, das mit einer wäßri gen Lösung von Polyvinylphosphonsäure vorbehandelt worden war. Der Träger wurde mit einer Lösung folgender Zusammensetzung überzogen:

| | |
|---|---|
| 2,84 Gt | einer 22,3 %igen Lösung eines Terpolymerisats aus Styrol, n-Hexylmethacrylat und Methacrylsäure (10:60:30) mit der Säurezahl 190 in Methylethylketon, |
| 1,49 Gt | des Umsetzungsprodukts von Triethanolamin mit 3 mol Isocyanatoethylmethacrylat, |
| 0,04 Gt | Eosin alkohollöslich (C.I. 45 386), |
| 0,03 Gt | 2,4-Bis-trichlormethyl-6-(4-styrylphenyl)-s-triazin und |
| 0,049 Gt | 9-Phenylacridin und |
| 0,1 Gt | Carbonylverbindung (Tabelle I) in |
| 22 Gt | Propylenglykolmonomethylether. |

Das Auftragen erfolgte durch Aufschleudern in der Weise, daß ein Trockengewicht von 2,0 bis 2,5 $g/m^2$

erhalten wurde. Anschließend wurde die Platte zwei Minuten bei 100°C im Umlufttrockenschrank getrocknet. Die Platte wurde dann mit einer ungefärbten 7 %igen wäßrigen Lösung von Polyvinylalkohol (12 % Restacetylgruppen, K-Wert 4) beschichtet. Nach dem Trocknen wurde eine Deckschicht mit einem Gewicht von 2 bis 2,5 g/m² erhalten. Die erhaltenen Druckplatten wurden mittels einer 5 kW-Metallhalogenidlampe im Abstand von 110 cm unter einem 13-stufigen Belichtungskeil mit Dichteinkrementen von 0,15 belichtet, auf den, soweit angegeben, zusätzlich ein Silberfilm mit gleichmäßiger Schwärzung (Dichte 1,57) und gleichmäßiger Absorption über den wirksamen Spektralbereich als Graufilter montiert wurde. Um die Empfindlichkeit der Druckplatten im sichtbaren Licht zu testen, wurden auf den Belichtungskeil jeweils 3 mm starke Kantenfilter der Firma Schott mit den in der Tabelle angegebenen Kantendurchlässigkeiten montiert. Zur Messung des spektralen Empfindlichkeitsbereichs der Platten wurde unter einem Interferenz-Verlauffilter von 300 bis 700 nm mit parallelem Licht einer 500 W-Glühlampe im Abstand von 75 cm belichtet. Nach der Belichtung wurde die Platte eine Minute auf 100° C erwärmt. Anschließend wurde sie mit einem Entwickler folgender Zusammensetzung entwickelt:

| | |
|---|---|
| 120 Gt | Natriummetasilikat · 9 $H_2O$, |
| 2,13 Gt | Strontiumchlorid, |
| 1,2 Gt | nichtionogenes Netzmittel (Kokosfettalkohol-Polyoxyethylenether mit ca. 8 Oxyethyleneinheiten) und |
| 0,12 Gt | Antischaummittel in |
| 4000 Gt | vollentsalztem Wasser. |

Nach dem Entwickeln wurde in den angegebenen Spektralbereichen vollständige Aushärtung gefunden. Das Auflösungsvermögen der Druckplatten wurde mit einer Testvorlage, dem PMS-Keil (FOGRA), bestimmt und an der Kopie abgelesen.

Tabelle I

| Carbonylverbindung | Belichtungszeit (Sekunden) | Spektralbereich (nm) | Auflösung (µm) |
|---|---|---|---|
| 4-Dimethylamino-4'-methoxy-dibenzal-aceton | 30 | 300 - 550 | 15 |
| 3-Acetyl-7-diethyl-amino-cumarin | 30 | 300 - 585 | 12 |

Ohne Carbonylverbindung erhielt man nach 30 Sekunden einen ausgehärteten Bereich von 300 - 430 nm und von 470 - 600 nm. Ohne Carbonylverbindung und ohne Farbstoff erhielt man einen gehärteten Bereich von 300 - 430 nm.

Die Platte ohne Carbonylverbindung wurde mit fetter Druckfarbe eingefärbt. Es wurden die folgenden vollvernetzten Keilstufen erhalten.

| Belichtung (Sekunden) | Graufilter | Kantenfilter | Keilstufen | Auflösung (µm) |
|---|---|---|---|---|
| 40 | ja | - | 5 | 25 |
| 40 | nein | 455 | 5 | 25 |

Beispiel 2

Auf den in Beispiel 1 angegebenen Schichtträger wurden Lösungen folgender Zusammensetzung so aufgeschleudert, daß jeweils ein Schichtgewicht von 2,0 g/m² erhalten wurde:

| | |
|---|---|
| 2,84 Gt | der in Beispiel 1 angegebenen Terpolymerisatlösung, |
| 1,49 Gt | der in Beispiel 1 angegebenen polymerisierbaren Verbindung, |
| 0,04 Gt | Farbstoff (Tabelle II), |
| 0,03 Gt | des in Beispiel 1 angegebenen s-Triazins und |
| 0,049 Gt | 9-Phenylacridin in |
| 22,0 Gt | Propylenglykolmonomethylether |

Die Platten der Versuche 1 bis 4, 6, 8 und 10 wurden dann wie in Beispiel 1 mit einer Polyvinylalkoholschicht überzogen. Auf die Platten der Versuche 5, 7 und 9 wurde eine Deckschicht gleicher Dicke aus einer Lösung aufgebracht, die zusätzlich 0,25 % Astrazonblau 3 RL (C.I. Basic Blue 47) enthielt.

Zur Messung der spektralen Empfindlichkeit wurde wie in Beispiel 1 belichtet und entwickelt. Die Tabellen II und III geben die Ergebnisse an:

Tabelle II:

| Versuch Nr. | Farbstoff (C.I. Nr.) | Belichtungszeit (s) | gehärtete Bereiche (nm) |
|---|---|---|---|
| 1 | Hämatoporphyrin | 120 | 300 - 640 |
| 2 | Thionin (52000) | 180 | 300 - 440 und 550 - 640 |
| 3 | Cyanosin (45410) | 60 | 300 - 450 und 490 - 620 |
| 4 | Eosin (alkohollöslich) (45386) | 60 | 300 - 430 und 470 - 600 |
| 5 | Pyronin GY (45005) | 120 | 300 - 450 und 480 - 530 |
| 6 | Rhodamin 6G (45160) | 60 | 300 - 480 und 510 - 600 |
| 7 | Erythrosin B (45430) | 90 | 300 - 440 und 480 - 560 |
| 8 | Methylenblau (52015) | 180 | 400 - 450 und 570 - 690 |
| 9 | Thioflavin T (49005) | 180 | 350 - 480 |
| 10 | Acriflaviniumchlorid | 90 | 350 - 520 |

Tabelle III:

| Versuch | Belichtungszeit (s) | gehärteter Bereich (nm) | Auflösung (µm) |
|---|---|---|---|
| 5 | 60 | 300 - 430 | 15 |
| 7 | 60 | 300 - 430 | 20 |
| 9 | 60 | 350 - 430 | 15 |

Beispiel 3

Auf die in Beispiel 1 hergestellte Druckplatte mit der Carbonylverbindung 4-Dimethylamino-4'-methoxydibenzalaceton wurde anstelle der ungefärbten PVA-Deckschicht eine Deckschicht folgender Zusammensetzung aufgeschleudert:

100 Gt einer 7 %igen wäßrigen Lösung von Polyvinylalkohol (12 % Restacetylgruppen, K-Wert 4) und
0,1 Gt Farbstoff (Tabelle IV)

Nach dem Trocknen wurde ein Schichtgewicht von 2 bis 2,5 g/m$^2$ erhalten. Die beschichteten Platten wurden unter einem Interferenz-Verlauffilter von 300 - 700 nm mit parallelem Licht einer 500 W-Glühbirne im Abstand von 75 cm belichtet und eine Minute im Umlufttrockenschrank erwärmt. Nach dem Entwickeln wie in Beispiel 1 wurden in den in Tabelle IV angegebenen Spektralbereichen Durchhärtung gefunden.

Tabelle IV:

| Farbstoff (C.I. Nr.) | Belichtungszeit (s) | Spektralbereich (nm) |
|---|---|---|
| Astrazonblau 3 RL (Basic Blue 47) | 60 | 300 - 450 |
| Viktoriablau FB (44045) | 60 | 300 - 450 |
| Astrazonblau B (42140) | 60 | 300 - 450 |
| Bromphenolblau wasserl. (CAS-62625-28-9) | 60 | 300 - 480 |
| Novofilgelb GR (Pigment Yellow 13) | 60 | 450 - 560 |
| Remazolgoldgelb G (Reactive Yellow 17) | 60 | 440 - 560 |
| Astrazongelbbraun 3 GL (Basic Orange 3012) | 60 | 480 - 560 |
| Maxilonrot BL-N (Basic Red 22) | 60 | 400 - 470 und 560 - 680 |
| Astrazonorange 3 R (Basic Orange 22) | 60 | 300 - 450 und 530 - 680 |
| Brillantgrün (42040) | 60 | 460 - 550 |
| Remazoltürkisblau G (Reactive Blue 21) | 60 | 400 - 600 |
| Nubilonorange R (Acid Orange 7) | 60 | 530 - 680 |

Beispiel 4

Auf den in Beispiel 1 angegebenen Schichtträger wurde unter gleichen Bedingungen wie dort eine Lösung folgender Zusammensetzung so aufgeschleudert, daß ein Schichtgewicht von 2,0 $g/m^2$ erhalten wurde.

| | |
|---|---|
| 1,4 Gt | der in Beispiel 1 angegebenen Terpolymerisatlösung, |
| 1,4 Gt | des Umsetzungsprodukts von Triethanolamin mit 3 mol Isocyanatoethylmethacrylat, |
| 0,001 Gt | Kristallviolettbase, |
| 0,04 Gt | Leukokristallviolett, |
| 0,04 Gt | 9-Phenylacridin, |
| 0,03 Gt | 2,4-Bis-trichlormethyl-6-(4-styryl-phenyl)-s-triazin und |
| 0,04 Gt | Dibenzalaceton in |
| 35,0 Gt | Propylenglykolmonomethylether |

Die Platten wurden mit PVA-Deckschichten nach Beispiel 3, hergestellt mit Astrazongelbbraun 3 GL, Astrazonblau 3 RL oder Victoriablau FB als Farbstoff versehen. Nach dem Trocknen wurde bei den Deckschichten ein Schichtgewicht von 2 g/m² erhalten. Die so erhaltenen Druckplatten wurden wie in Beispiel 1, jedoch stets mit Graufilter, belichtet.

Die Wirksamkeit des zugesetzten Farbstoffs in der Deckschicht hinsichtlich des Auflösungsvermögens wurde mit einer Testvorlage, dem FOGRA-PMS-Keil, bestimmt und an der Kopie abgelesen.

Bei einem Druckversuch wurden 200.000 saubere Drucke erhalten.

Tabelle V:

| Farbstoff | Belichtungszeit (s) | Keilstufen | Auflösung (µm) |
|---|---|---|---|
| Astrazongelbbraun 3 GL | 30 | 5 | 10 |
| Astrazonblau 3 RL | 20 | 5 | 12 |
| Victoriablau FB | 20 | 5 | 12 |

Beispiel 5:

Auf die in Beispiel 1 hergestellte Druckplatte mit 4-Dimethylamino-4'-methoxydibenzalaceton wurde anstelle der ungefärbten PVA-Deckschicht eine Deckschicht folgender Zusammensetzung aufgeschleudert:

100 Gt einer 7 %-igen wäßrigen Lösung von Polyvinylalkohol (12 % Restacetylgruppen K-Wert 4),
0,1 Gt Astrazonblau 3 RL und
0,1 Gt Maxilongelb 2 RL

Nach dem Trocknen wurde ein Schichtgewicht von 2 - 2,5 g/m² erhalten. Die Platten wurden, wie in Beispiel 1 beschrieben, 60 Sekunden unter einem Interferenz-Verlauffilter belichtet und entwickelt. Es wurde ein durchgehärteter Spektralbereich von 300 bis 400 nm gefunden. Die Auflösung der Kopie, bestimmt mit dem PMS-Keil, betrug 10 µm.

Beispiel 6

Auf den im Beispiel 1 angegebenen Schichtträger wurde unter gleichen Bedingungen wie dort eine Lösung folgender Zusammensetzung so aufgeschleudert, daß ein Schichtgewicht von 2,0 g/m² erhalten wurde.

1,4 Gt der in Beispiel 1 angegebenen Terpolymerisatlösung,
1,4 Gt des Umsetzungsprodukts von 2-Piperidinoethanol mit 2 mol Isocyanatoethylmethacrylat,
0,04 Gt Eosin aikohollöslich (C.I. 45386),
0,03 Gt 2,4-Bis-trichlormethyl-6-(4-styryl-phenyl)-s-triazin,
0,049 Gt 9-Phenylacridin und
22,0 Gt Propylenglykolmonomethylether

Diese Druckplatte wurde in zwei Hälften geteilt. Auf die eine Hälfte wurde eine PVA-Deckschicht aus einer 7 %-igen wäßrigen Lösung von Polyvinylalkohol (12 % Restacetylgruppen, K-Wert 8) aufgeschleudert (Platte A).

Die zweite Hälfte (Platte B) wurde mit einer gefärbten Deckschicht folgender Zusammensetzung versehen:

100 Gt einer 7%-igen wäßrigen Lösung von Polyvinylalkohol (12 % Restacetylgruppen, K-Wert 8) und
0,07 Gt Astrazonblau 3 RL

Nach dem Trocknen wurde bei beiden Druckplatten ein Schichtgewicht von 2 g/m² erhalten. Die so erhaltenen Druckplatten wurden wie im Beispiel 4 belichtet. Die Wirksamkeit des Farbstoffs hinsichtlich des Auflösungsvermögens wurde mit einer Testvorlage, dem FOGRA-PMS-Keil, bestimmt und an der Kopie abgelesen. Um die Empfindlichkeit der Druckplatten im sichtbaren Spektralbereich zu testen, wurde auf den Belichtungskeil ein Kantenfilter montiert. Nach der Belichtung wurden die Platten 1 Minute auf 100°C im Trockenschrank erwärmt und wie in Beispiel 1 entwickelt.

Tabelle VI

| | Belichtung (s) | Graufilter | Kantenfilter (nm) | Keilstufen | Auflösung (µm) |
|---|---|---|---|---|---|
| Platte A | 20 | ja | - | 6 | 25 |
| | | nein | 455 | 4 | 25 |
| Platte B | 20 | ja | - | 6 | 12 |
| | | nein | 455 | - | - |

Die Platte B war bei Wellenlängen oberhalb 455 nm nicht mehr empfindlich.

**Patentansprüche**

1. Photopolymerisierbares Aufzeichnungsmaterial mit einem Schichtträger, einer photopolymerisierbaren Schicht, die als wesentliche Bestandteile ein polymeres Bindemittel, eine radikalisch polymerisierbare Verbindung mit mindestens einer endständigen ethylenisch ungesättigten Gruppe und mindestens einer bei Belichtung in Gegenwart eines photoreduzierbaren Farbstoffs photooxydierbaren Gruppe sowie einen durch aktinisches Licht aktivierbaren photoreduzierbaren Farbstoff als Polymerisationsinitiator enthält, und einer Deckschicht, die ein für Luftsauerstoff wenig durchlässiges, in Wasser oder einem Wasser/Alkohol-Gemisch lösliches Polymeres und ferner einen in Wasser bei 20 °C löslichen Farbstoff oder ein entsprechendes Gemisch von Farbstoffen enthält, die im Bereich von 300 bis 700 nm Licht absorbieren und innerhalb dieses Bereichs eine Absorptionslücke haben, die dem Emissionsbereich der gewünschten Kopierlichtquelle entspricht.

2. Aufzeichnungsmaterial nach Anspruch 1, dadurch gekennzeichnet, daß der Farbstoff ein Di- oder Triarylcarbenium-, Azo-, Aza(18)annulen-, Nitro-, Nitroso-, Polymethin-, Carbonyl- oder Schwefelfarbstoff ist.

3. Aufzeichnungsmaterial nach Anspruch 1, dadurch gekennzeichnet, daß die Deckschicht ein Flächengewicht von 0,2 bis 10 $g/m^2$ hat.

4. Aufzeichnungsmaterial nach Anspruch 1, dadurch gekennzeichnet, daß die Deckschicht 0,05 bis 50 Gew.-% Farbstoff enthält.

5. Aufzeichnungsmaterial nach Anspruch 1, dadurch gekennzeichnet, daß die Deckschicht im Absorptionsbereich des Farbstoffs eine optische Dichte von 0,5 bis 2,5 hat.

6. Aufzeichnungsmaterial nach Anspruch 1, dadurch gekennzeichnet, daß der Emissionsbereich der Kopierlichtquelle bei 350 bis 400, bei 400 bis 450 oder bei 488 und 514 nm liegt.

7. Aufzeichnungsmaterial nach Anspruch 1, dadurch gekennzeichnet, daß die radikalisch polymerisierbare Verbindung ein Acryl- oder Alkacrylsäureester eines mehrwertigen Alkohols ist.

8. Aufzeichnungsmaterial nach Anspruch 1, dadurch gekennzeichnet, daß die radikalisch polymerisierbare Verbindung ein Acryl- oder Alkacrylsäureester eines mehrwertigen Alkohols mit mindestens einer bei Belichtung in Gegenwart des photoreduzierbaren Farbstoffs photooxydierbaren Gruppe ist.

9. Aufzeichnungsmaterial nach Anspruch 1, dadurch gekennzeichnet, daß es als Photoinitiator ferner eine photolytisch spaltbare Trihalogenmethylverbindung und eine als Photoinitiator wirksame Acridin-, Phenazin- oder Chinoxalinverbindung enthält.

10. Aufzeichnungsmaterial nach Anspruch 1, dadurch gekennzeichnet, daß das Bindemittel wasserunlöslich und in wäßrig-alkalischen Lösungen löslich ist.

11. Aufzeichnungsmaterial nach Anspruch 1, dadurch gekennzeichnet, daß die photopolymerisierbare Schicht ein Flächengewicht von 0,5 bis 20 g/m$^2$ hat.

12. Aufzeichnungsmaterial nach Anspruch 1, dadurch gekennzeichnet, daß der Schichtträger eine hydrophile, für den Flachdruck geeignete Oberfläche hat.

## Claims

1. A photopolymerizable recording material which is comprised of a layer support, of a photopolymerizable layer comprising, as essential constituents, a polymeric binder, a compound which can be polymerized by a free-radical reaction and possesses at least one terminal, ethylenically unsaturated group and at least one group which is photooxidizable upon exposure in the presence of a photoreducible dye, and a photoreducible dye which can be activated by actinic light as polymerization initiator, and of a cover layer containing a polymer which possesses low permeability to atmospheric oxygen and is soluble in water or a water/alcohol mixture, and a dye or an appropriate mixture of several dyes, which at 20 °C are soluble in water, absorb light in the range of 300 to 700 nm and within this range have a non-absorbent region corresponding to the emission range of the desired copying light source.

2. Recording material as claimed in claim 1, characterized in that the dye is a di- or triarylcarbenium dye, an azo dye, an aza(18)annulene dye, a nitro dye, a nitroso dye, a polymethine dye, a carbonyl dye or a sulphur dye.

3. Recording material as claimed in claim 1, characterized in that the cover layer has a weight per unit area of between 0.2 g/m$^2$ and 10 g/m$^2$.

4. Recording material as claimed in claim 1, characterized in that 0.05 to 50 % by weight of dye are contained in the cover layer.

5. Recording material as claimed in claim 1, characterized in that in the absorption region of the dye the cover layer has an optical density between 0.5 and 2.5.

6. Recording material as claimed in claim 1, characterized in that the emission range of the copying light source is 350 to 400 nm, 400 to 450 nm or 488 and 514 nm.

7. Recording material as claimed in claim 1, characterized in that the free-radical-polymerizable compound is an acrylic or alkacrylic acid ester of a polyhydric alcohol.

8. Recording material as claimed in claim 1, characterized in that the free-radical-polymerizable compound is an acrylic or alkacrylic acid ester of a polyhydric alcohol possessing at least one group which is photooxidizable by exposure in the presence of the photoreducible dye.

9. Recording material as claimed in claim 1, characterized in that it furthermore contains a photolytically cleavable trihalomethyl compound as photoinitiator and an acridine, phenazine or quinoxaline compound acting as photoinitiator.

10. Recording material as claimed in claim 1, characterized in that the binder is water-insoluble and soluble in aqueous-alkaline solutions.

11. Recording material as claimed in claim 1, characterized in that the photopolymerizable layer has a weight per unit area of 0.5 to 20 g/m$^2$.

12. Recording material as claimed in claim 1, characterized in that the layer support has a hydrophilic surface suitable for planographic printing.

## Revendications

1. Matériau d'enregistrement photopolymérisable avec une couche support, une couche photopolymérisable qui contient, comme constituants essentiels, un liant polymère, un composé polymérisable par voie radicalaire présentant au moins un groupe terminal éthyléniquement insaturé et au moins un groupe photooxydable par exposition à la lumière en présence d'un colorant photoréductible, ainsi qu'un colorant photoréductible pouvant être activé au moyen d'un rayonnement actinique, comme initiateur de polymérisation, et une couche de revêtement contenant un polymère qui laisse peu passer l'oxygène de l'air et est soluble dans l'eau ou dans un mélange d'eau et d'alcool, ainsi qu'un colorant soluble dans l'eau à 20°C ou un mélange correspondant de colorants qui absorbent la lumière dans la plage de 300 à 700 nm et présentent, dans cette plage, un point de non-absorption qui correspond à la plage d'émission de la source lumineuse souhaitée de reproduction.

2. Matériau d'enregistrement selon la revendication 1, caractérisé en ce que le colorant est un colorant du type di- ou triarylcarbénium, azoïque, aza(18)annulène, nitro, nitroso, polyméthine, carbonyle ou à base de soufre.

3. Matériau d'enregistrement selon la revendication 1, caractérisé en ce que la couche de revêtement a un poids surfacique de 0,2 à 10 $g/m^2$.

4. Matériau d'enregistrement selon la revendication 1, caractérisé en ce que la couche de revêtement contient de 0,05 à 50 % en poids de colorant.

5. Matériau d'enregistrement selon la revendication 1, caractérisé en ce que la couche de revêtement a une densité optique de 0,5 à 2,5 dans la plage d'absorption du colorant.

6. Matériau d'enregistrement selon la revendication 1, caractérisé en ce que la plage d'émission de la source lumineuse de reproduction est de 350 à 400, de 400 à 450 ou de 488 et de 514 nm.

7. Matériau d'enregistrement selon la revendication 1, caractérisé en ce que le composé polymérisable par voie radicalaire est un ester acrylique ou alkacrylique d'un polyol.

8. Matériau d'enregistrement selon la revendication 1, caractérisé en ce que le composé polymérisable par voie radicalaire est un ester acrylique ou alkacrylique d'un polyol présentant au moins un groupe photooxydable par exposition à la lumière en présence d'un colorant photoréductible.

9. Matériau d'enregistrement selon la revendication 1, caractérisé en ce qu'il contient, en outre, comme photoinitiateur, un composé trihalogénométhyle dissociable par photolyse, et un composé acridine, phénazine ou quinoxaline agissant comme un photo-initiateur.

10. Matériau d'enregistrement selon la revendication 1, caractérisé en ce que le liant est insoluble dans l'eau et soluble dans des solutions aqueuses alcalines.

11. Matériau d'enregistrement selon la revendication 1, caractérisé en ce que la couche photopolymérisable a un poids surfacique de 0,5 à 20 $g/m^2$.

12. Matériau d'enregistrement selon la revendication 1, caractérisé en ce que la couche support a une surface hydrophile appropriée à l'impression à plat.